(19) **Europäisches Patentamt**

**European Patent Office**

**Office européen des brevets**

(11) **EP 0 664 569 B1**

(12) **EUROPÄISCHE PATENTSCHRIFT**

(45) Veröffentlichungstag und Bekanntmachung des Hinweises auf die Patenterteilung:
**10.05.2000 Patentblatt 2000/19**

(51) Int. Cl.$^7$: **H01L 45/00**

(21) Anmeldenummer: **95100274.0**

(22) Anmeldetag: **10.01.1995**

(54) **Mikroelektronisches Bauelement**

Microelectronics device

Dispositif microélectronique

(84) Benannte Vertragsstaaten:
**DE FR GB IT**

(30) Priorität: **19.01.1994 DE 4401442**

(43) Veröffentlichungstag der Anmeldung:
**26.07.1995 Patentblatt 1995/30**

(73) Patentinhaber:
**SIEMENS AKTIENGESELLSCHAFT**
**80333 München (DE)**

(72) Erfinder:
• **Vogelsang, Thomas**
**Essex Junction, VT 05452 (US)**
• **Rösner, Wolfgang, Dr.**
**D-81739 München (DE)**

(56) Entgegenhaltungen:
**EP-A- 0 414 205**    **EP-A- 0 576 263**
**DE-A- 4 212 220**

## Beschreibung

Mikroelektronische Bauelemente, bei denen ein quantenmechanischer Effekt ausgenutzt wird, gewinnen im Hinblick auf die Entwicklung sehr schneller elektronischer Bauelemente mit hohem Integrationsgrad an Bedeutung. Das Interesse richtet sich dabei unter anderem auf den Effekt der Coulomb-Blockade, der in K. K. Likharev, Granular Nanoelectronics, D. K. Ferry ed., Plenum, N. Y. (1991) S. 371 ff. beschrieben wird.

Die Coulomb-Blockade beruht auf dem Effekt, daß sich beim Tunneln eines Elektrons über einen Tunnelkontakt die Energie des Gesamtsystems ändert. Unter Tunnelkontakt versteht man eine Struktur, die zwei durch eine Isolierschicht getrennte Elektroden umfaßt, wobei die Isolierschicht so dünn ist, daß es zu einem Tunneln einzelner Elektronen durch die Isolierschicht kommt. Die Energieänderung des Gesamtsystems liegt dabei in der Größenordnung $q_e^2/C$, wobei $q_e$ die Ladung eines Elektrons und C die Kapazität des Tunnelkontakts ist. Ist diese Energieänderung eine Energieerhöhung deutlich über der thermischen Energie des Systems $k_BT$, wobei $k_B$ die Boltzmannkonstante und T die absolute Temperatur ist, so tritt ein Tunneln des Elektrons durch den Tunnelkontakt nicht auf. Damit ist der Strom durch den Tunnelkontakt blockiert. Liegt dagegen die Energieänderung in der Größenordnung der oder ist kleiner als die thermische Energie, das heißt $q_e^2/C \lesssim k_BT$, so kann es zum Tunneln eines Elektrons über den Tunnelkontakt kommen.

Die Ausnutzung der Coulomb-Blockade ist daher einerseits möglich bei Strukturen im Bereich 30 bis 100 nm, die im Millikevinbereich betrieben werden (siehe zum Beispiel A. Gladun et al, Physik in unserer Zeit, Bd. 23 (1992), S. 159 ff. und L. J. Geerligs et al, Phys. Rev. Lett. Bd. 65 (1990), S. 3037 ff.) oder bei Strukturen mit einer Größe deutlich unter 10 nm, die bei höheren Temperaturen betrieben werden (siehe zum Beispiel C. Schönenberger et al, Europhys. Lett. Bd. 20 (1992), S. 249 ff.).

Als Tunnelkontakt im ersten Fall werden zum Beispiel zwei Elektroden aus Aluminium verwendet, zwischen denen eine dünne Oxidschicht angeordnet ist (siehe A. Gladun et al, Physik in unserer Zeit, Bd. 23 (1992), S. 159 ff.). Ein solches Coulombblockadebauelement ist nur bei sehr tiefen Temperaturen funktionsfähig. Die elektrischen Eigenschaften dieses Tunnelkontaktes lassen sich über Skalierung der Komponenten einstellen.

Der Coulomb-Blockade-Effekt bei Raumtemperatur tritt nach der Abschätzung über die Energieänderung und thermische Energie nur bei Elementen auf mit einem Tunnelkontakt mit einer Kapazität von Attofarad ($10^{-18}$ F) oder darunter. Derartige Elemente weisen eine Ausdehnung in der Größenordnung einiger Nanometer auf.

Die Kontaktierung derartig kleiner Elemente erfolgt mit Hilfe von Rastermikroskopen, wie dem Rastertunnelmikroskop oder dem Atomkraftmikroskop (siehe C. Schönenberger et al, Europhys. Lett. Bd. 20 (1992) S. 249 ff.). Andere Möglichkeiten, Elemente dieser Größenordnung zu kontaktieren, sind nicht bekannt.

Als Tunnelkontaktelemente in Nanometergröße sind Metallcluster vorgeschlagen worden, die von einer isolierenden Hülle umgeben sind (siehe DE 42 12 220 A1). Die elektrischen Eigenschaften dieser Tunnelkontaktelemente sind durch die Größe und Art der Metallcluster sowie der isolierenden Hüllen vorgegeben.

In DE 42 12 220 A1 werden zur Kontaktierung einzelner Tunnelelemente Mikroelektroden, das heißt Rastermikroskope, verwendet. Eine solche Kontaktierung ist zwar zur Erprobung und wissenschaftlichen Untersuchung derartiger Tunnelelemente zweckmäßig, für den Einsatz der Tunnelelemente als mikroelektronisches Bauelement innerhalb einer komplexen Schaltungsanordnung jedoch ungeeignet.

Als praktische Ausführungsform wird in DE 42 12 220 A1 beschrieben, die Einzelelemente als Schüttung in einer Aufnahmefassung aufzunehmen und über die Aufnahmefassung entsprechend zu kontaktieren bzw. einen Preßkörper durch Verpressen der Einzelelemente unter hohem Druck zu bilden, der mit Kontakten versehen wird. Auf diese Weise werden Bauelementkörper als Scheibe mit einem Durchmesser von 5 mm und einer Dicke von 0,379 mm gebildet. Bevorzugt werden Abmessungen von 2 bis 10 mm für den Durchmesser und 0,1 bis 1 mm für die Dicke. Derartige Bauelemente weisen eine Einsatzspannung in der Größenordnung von Kilo-Volt auf, was für den Einsatz in der Mikroelektronik ungünstig ist.

Der Erfindung liegt das Problem zugrunde, ein mikroelektronisches Bauelement anzugeben, das skalierbar und lithographisch herstellbar ist. Darüber hinaus soll ein Bauelement angegeben werden, das bei Raumtemperatur funktionsfähig ist.

Dieses Problem wird erfindungsgemäß gelöst durch ein mikroelektronisches Bauelement gemäß Anspruch 1. Weitere Ausgestaltungen der Erfindung gehen aus den übrigen Ansprüchen hervor.

In dem erfindungsgemäßen Bauelement sind auf einer Hauptfläche eines Substrats in einer Lage nebeneinander Einzelelemente angeordnet, die eine Schichtstruktur bilden. Die Einzelelemente sind untereinander über quantenmechanische Tunnelkontakte verbunden. Das bedeutet, daß jedes Einzelelement einen elektrisch leitfähigen Bereich umfaßt und über eine Isolierschicht gegenüber dem elektrisch leitfähigen Bereich der benachbarten Einzelelemente isoliert ist. Die Isolierschicht ist so dimensioniert, daß die leitfähigen Bereiche benachbarter Einzelelemente und die dazwischen angeordnete Isolierschicht einen Tunnelkontakt bilden.

Als Einzelelemente kommen alle Strukturen in Betracht, die diese Bedingung erfüllen. Insbesondere sind als Einzelelemente Strukturen geeignet, die einen leitfähigen Kern und eine den leitfähigen Kern umgebende isolierende Hülle umfassen. Der Durchmesser des Einzelelementes liegt dabei vorzugsweise zwischen 1 und 10 nm. Die Kapazität der Einzelelemente ist in diesem Größenbereich so klein, daß das Bauelement im Raumtemperaturbereich funktioniert. Insbesondere sind als Einzelelemente Metallcluster mit organischen Liganden als isolierende Hülle, wie aus DE 42 12 220 A1 bekannt, oder Fullerene mit eingeschlossenem Metallkern geeignet.

Weitere als Einzelelemente geeignete Materialien sind auch in M. P. J. van Staveren et al, Phys. Rep. Bd. 208 (991) Nr. 1, aufgeführt, dort allerdings nicht als Schichtstruktur sondern als Volumenmaterial.

Es liegt weiterhin im Rahmen der Erfindung, die Schichtstruktur aus einem porösen Halbleitermaterial, vorzugsweise Silizium, zu bilden, das so stark ausgeätzt ist, daß keine durchgehende leitfähige Verbindung über die Poren mehr besteht. Als leitfähige Bereiche wirken in derartigen porösen Halbleitermaterialien zwischen den Poren befindliche Körner des Halbleitermaterials. Als poröses Halbleitermaterial ist insbesondere poröses Silizium, das durch anodische Ätzung in einem fluoridhaltigen Elektrolyten gebildet wird, geeignet.

In dem mikroelektronischen Bauelement sind mindestens zwei Kontaktstrukturen vorgesehen, die mit der Schichtstruktur elektrisch verbunden sind. Die zwei Kontaktstrukturen sind vorzugsweise an gegenüberliegenden Seiten der Schichtstruktur angeordnet. Die Kontaktstrukturen sind dabei so auf der Hauptfläche des Substrats angeordnet, daß am Rand der Schichtstruktur befindliche Einzelelemente mit der jeweiligen Kontaktstruktur in Berührung sind. Gegenüberliegende Kontaktstrukturen weisen einen Abstand von vorzugsweise zwischen 20 und 500 nm auf. Senkrecht dazu weist die Schichtstruktur eine Ausdehnung zwischen 20 nm und 10 µm auf. Derartige Abmessungen sind mit Hilfe von Elektronenstrahllithographie oder Deep-UV-Lithographie herstellbar.

Die Kontaktstrukturen werden vorzugsweise aus dotiertem Polysilizium oder aus einem Metall gebildet.

Die Schichtstruktur und die Kontaktstrukturen sind gegenüber dem Substrat elektrisch isoliert. Wird als Substrat ein isolierendes Material wie zum Beispiel Glas oder Saphir verwendet, sind zur Isolation keine zusätzlichen Maßnahmen erforderlich. Wird als Substrat Silizium verwendet, so wird die Isolation durch eine isolierende Schicht sichergestellt, an deren Oberfläche die Kontaktstrukturen und die Schichtstrukturen angeodneten sind.

Beträgt der Abstand zwischen den beiden Kontaktstrukturen L und die Größe der Einzelelemente a, so fällt beim Anlegen einer Spannung U zwischen den beiden Kontaktstrukturen zwischen zwei Einzelelementen, die in Richtung von L benachbart sind, eine Spannung $U/(L/a)$ ab. Dabei wird eine gleichmäßige Ladungsverteilung angenommen. Beträgt dieser Spannungsanteil je Einzelelement weniger als die Schwellenspannung der Coulomb-Blockade, so sperrt das mikroelektronische Bauelement. Beträgt dieser Anteil dagegen mehr als die Schwellenspannung der Coulomb-Blockade, so leitet das mikroelektronische Bauelement. Die Schwellenspannung des Bauelementes ist, wenn jedes Einzelelement sechs Nachbarn hat, gegeben durch $U_{th}=q_e L/6Ca$, wobei C die Kapazität zwischen zwei benachbarten Einzelelementen ist. Beträgt zum Beispiel die Ausdehnung der Einzelelemente 2 nm, die Kapazität 0,5 aF und der Abstand zwischen den Kontaktstrukturen 50 nm, so beträgt die Schwellenspannung für das gesamte mikroelektronische Bauelement 1,3 Volt. Das heißt, wird zwischen die Kontaktstrukturen eine Spannung kleiner 1,3 Volt angelegt, so sperrt das Bauelement, wird dagegen eine Spannung größer 1,3 Volt angelegt so leitet das Bauelement. Diese Schwellenspannung liegt in einer Größe, die für integrierte Schaltungen vernünftig nutzbar ist.

Es liegt im Rahmen der Erfindung, eine Oberfläche der Schichtstruktur, die parallel zur Hauptfläche des Substrats ausgerichtet ist, mit einem Gatedielektrikum zu versehen. Auf der Oberfläche des Gatedielektrikums ist eine Gateelektrode angeordnet, die durch das Gatedielektrikum gegenüber der Schichtstruktur und den Kontaktstrukturen isoliert ist. Durch Anlegen einer Steuerspannung an die Gateelektrode läßt sich die Schwellenspannung für die Coulomb-Blockade beeinflussen. Diese Ausführungsform des erfindungsgemäßen mikroelektronischen Bauelementes stellt ein steuerbares Coulomb-Blockade-Bauelement dar.

Wird diese Ausführungsform des erfindungsgemäßen Bauelementes mit Hilfe eines Substrats aus Silizium realisiert, so ist es vorteilhaft, auf das Substrat zunächst die Gateelektrode, darauf das Gatedielektrikum und darauf die Kontaktstrukturen und die Schichtstruktur aufzubringen. Die Kontaktstrukturen und die Schichtstruktur sind in diesem Fall durch das Gatedielektrikum gegenüber dem Substrat elektrisch isoliert. Auf diese Weise können zunächst die Siliziumprozeßschritte durchgeführt werden, ehe zwischen den Kontaktstrukturen die Schichtstruktur abgeschieden wird. Es liegt insbesondere im Rahmen der Erfindung, die Gateelektrode in diesem Fall als implantiertes Diffusionsgebiet in der Oberfläche des Substrats zu realisieren.

Gemäß einer Ausgestaltung dieser Ausführungsform werden auf der Oberfläche des Gatedielektrikums mindestens zwei Gateelektroden angeordnet. Dadurch läßt sich das erfindungsgemäße Bauelement als Elektronen-Pumpe, wie es zum Beispiel aus C. Urbina et al, IEEE Trans. Magn. Bd. 27 (1991) S. 2578 ff. bekannt ist, einsetzen. In einer solchen Elektronen-Pumpe kann durch Anlegen von geeigneten Wechselspannungen an die Gate-Elektroden jeweils eine bestimmte Ladungsmenge pro Periode durch die Anordnung laufen. Dadurch kann man einen Gleichstrom erzeugen, dessen Größe von der Frequenz der Wechselspannung kontrolliert wird.

Im folgenden wird die Erfindung anhand der Ausführungsbeispiele und der Figuren näher erläutert.

Figur 1    stellt eine Aufsicht auf eine Diodenstruktur gemäß der Erfindung dar.

Figur 2    zeigt den in Figur 1 mit II-II bezeichneten Schnitt durch die Diodenstruktur.

Figur 3    zeigt die Kennlinie der in Figur 1 und Figur 2 dargestellten Diodenstruktur.

Figur 4    zeigt eine Aufsicht auf ein erfindungsgemäßes Bauelement mit einer Gateelektrode.

Figur 5    zeigt den in Figur 4 mit V-V bezeichneten Schnitt.

Figur 6    zeigt eine Aufsicht auf ein Bauelement mit zwei Gateelektroden, das als Drehtüranordnung einsetzbar ist.

Figur 7    zeigt den in Figur 6 mit VII-VII bezeichneten Schnitt.

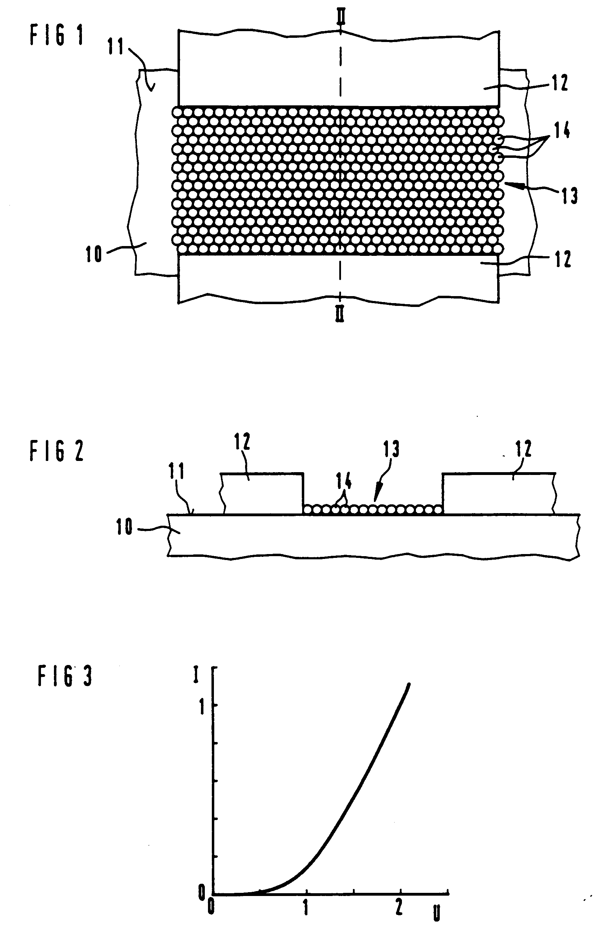

Ein Substrat 10 weist eine Hauptfläche 11 auf (siehe Figur 1 und Figur 2). Das Substrat 10 ist mindestens im Bereich der Hauptfläche 11 isolierend. Es besteht zum Beispiel aus Silizium mit einer $SiO_2$-Schicht im Bereich der Hauptfläche 11. Alternativ besteht das Substrat aus Glas oder Saphir.

Auf der Hauptfläche 11 des Substrats 10 sind zwei Kontaktstrukturen 12 angeordnet. Die Kontaktstrukturen 12 bestehen zum Beispiel aus dotiertem Polysilizium oder einem Metall, vorzugsweise Aluminium oder Titan. Parallel zur Hauptfläche 11 weisen die Kontaktstrukturen 12 eine Weite von zum Beispiel 1 µm auf. Die Kontaktstrukturen 12 können als Teil von Zuleitungen ausgeführt sein oder über ein Kontaktloch nach außen kontaktiert werden. Der Abstand zwischen den beiden Kontaktstrukturen 12 beträgt zum Beispiel 50 nm. Zwischen den beiden Kontaktstrukturen 12 ist eine Schichtstruktur 13 angeordnet. Die Schichtstruktur 13 umfaßt Einzelelemente, die als einlagige Schicht auf der Hauptfläche 11 angeordnet sind. Dabei berühren sich benachbarten Einzelelemente 14 untereinander. Einzelelemente 14, die am Rand der Schichtstruktur 13 angeordnet sind und an eine Kontaktstruktur 12 angrenzen, stehen mit der jeweiligen Kontaktstruktur 12 in Berührung. Senkrecht zur Verbindungslinie zwischen den Kontaktstrukturen 12 weist die Schichtstruktur eine Ausdehnung von zum Beispiel 1 µm auf.

Die Einzelelemente 14 sind zum Beispiel Metallcluster mit organischen Liganden, die eine isolierende Hülle um das Metallcluster bilden, Fullerene mit eingeschlossenem Metallkern oder poröses Halbleitermaterial, das so stark ausgeätzt ist, daß keine durchgehende leitfähige Verbindung mehr besteht und daß das Halbleitermaterial im wesentlichen aus Poren und Halbleiterkörnern besteht. Vorzugsweise werden als Einzelelement 14 Metallcluster mit einer Hülle aus organischen Liganden verwendet, wobei das Metallcluster 55 Goldatome umfaßt. Ein derartiges Einzelelement 14 weist einen Durchmesser von etwa 2 nm auf. Die Kapazität zwischen benachbarten Einzelelementen ist etwa 0,2 aF.

Benachbarte Einzelelemente 14 sind über einen Tunnelkontakt miteinander verbunden. Wird zwischen die Kontaktstrukturen 12 eine Spannung angelegt, die so groß ist, daß der Spannungsabfall über ein einzelnes Einzelelement 14 kleiner als die Schwellenspannung $u_{th}$ eines Tunnelkontaktes ist, so kann kein Strom durch die Schichtstruktur 13 fließen. Ist dagegen die Spannung zwischen den Kontaktstrukturen 12 so groß, daß der Spannungsabfall über jedes Einzelelement 14 größer als die Schwellenspannung $u_{th}$ für den Tunnelkontakt ist, so können Elektronen über die Tunnelkontakte tunneln und es kommt zu einem Stromfluß zwischen den Kontaktstrukturen 12 durch die Schichtstruktur 13.

Figur 3 zeigt die Strom(I)-Spannung (U)-Kennlinie der anhand von Figur 1 und Figur 2 erläuterten Diodenstruktur. Der Strom I ist angegeben in Einheiten $I_o = (W.U_{th})/(L.R_T)$. Dabei ist $R_T$ der Widerstand eines Tunnelkontaktes und W die Ausdehnung der Kontaktstrukturen 12 senkrecht zum Abstand der Kontaktstrukturen 12. $U_{th}$ beträgt zum Beispiel 1,3 V, $R_T$ beträgt zum Beispiel 100 kΩ, W beträgt zum Beispiel 1 µm, L beträgt zum Beispiel 50 nm. U ist angegeben in Einheiten der Schwellenspannung $U_{th}$ des Gesamtbauelementes.

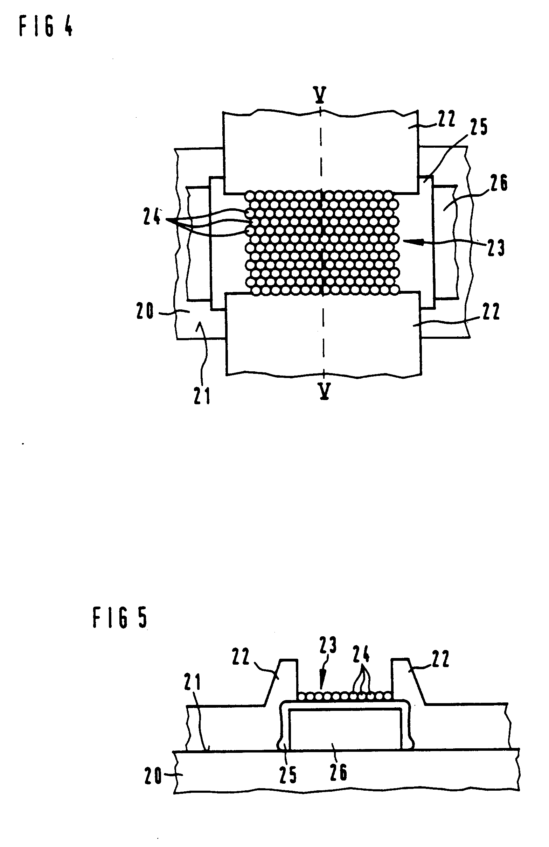

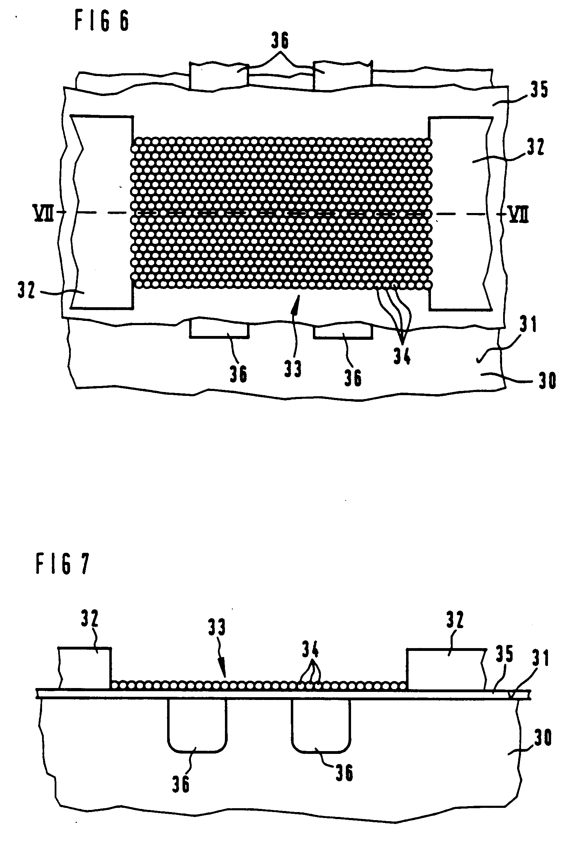

Ein Substrat 20 umfaßt eine Hauptfläche 21 (siehe Figur 4 und Figur 5). Das Substrat 20 ist an der Hauptfläche 21 isolierend. Das Substrat 20 besteht vorzugsweise aus Silizium mit einer $SiO_2$-Schicht. Alternativ besteht das Substrat 20 durchgehend aus isolierendem Material, zum Beispiel aus Glas oder Saphir.

Auf der Hauptfläche 21 sind neben zwei Kontaktstrukturen 22, einer Schichtstruktur 23, die aus einer einlagigen Schicht von Einzelelementen 24 besteht, ein Gatedielektrikum 25 und eine Gateelektrode 26 angeordnet. Auf der Hauptfläche 21 ist die Gateelektrode 26 angeordnet. Die Gateelektrode 26 besteht zum Beispiel aus dotiertem Polysilizium oder aus einem Metall, vorzugsweise Aluminium oder Titan. Die Gateelektrode 26 weist eine Dicke von zum Beispiel 50 nm auf.

Auf der Oberfläche der Gateelektrode 26 ist ein Gatedielektrikum 25 angeordnet. Das Gatedielektrikum 25 umfaßt zum Beispiel $SiO_2$ und weist eine Dicke von zum Beispiel 10 nm auf.

Die Kontaktstrukturen 22 sind an gegenüberliegenden Seiten der Gateelektrode 26 angeordnet. Vorzugsweise überlappen die Kontaktstrukturen 22 den Rand des Gatedielektrikums 25. Die Kontaktstrukturen 22 weisen einen Abstand von zum Beispiel 50 nm auf. Die Kontaktstrukturen 22 weisen parallel zur Hauptfläche 21 eine Weite von zum Beispiel 1 µm auf. Die Dicke der Kontaktstrukturen 22 beträgt zum Beispiel 50 nm.

Die Schichtstruktur 23 ist auf der Oberfläche des Gatedielektrikums 25 zwischen den Kontaktstrukturen 22 angeordnet. Die Schichtstruktur 23 umfaßt die Einzelelemente 24, die in einer Lage angeordnet sind. Dabei berühren sich benachbarte Einzelelemente 24. Einzelelemente 24, die an der an die Kontaktstrukturen 22 angrenzenden Seiten der Schichtstruktur 23 angeordnet sind, berühren die jeweilige Kontaktstruktur 22.

Die Einzelelemente 24 sind vorzugsweise Metallcluster aus 55 Goldatomen, die von einer Hülle aus einem organischen Liganden umgeben sind. Alternativ können die Einzelelemente 24 andere Metallcluster mit einer organischen Ligandenhülle, Fullerene mit eingeschlossenem Metallkern oder poröse Halbleitermaterialien sein.

Durch Anlegen einer Steuerspannung an die Gateelektrode 26 ändert sich die Höhe der Potentialbarriere der Tunnelkontakte, die zwischen benachbarten Einzelelementen 24 besteht. Für eine gegebene Spannung zwischen den Kontaktstrukturen 22 läßt sich daher durch Veränderung der Steuerspannung an der Gateelektrode 26 ein Strom zwischen den Kontaktstrukturen 22 beeinflussen.

Ein Substrat 30 weist eine Hauptfläche 31 auf. Auf der Hauptfläche 31 sind neben Kontaktstrukturen 32, einer Schichtstruktur 33, die in einer Lage angeordnete Einzelelemente 34 umfaßt, ein Gatedielektrikum 35 angeordnet. Das Substrat 30 umfaßt zwei Gateelektroden 36, die an die Hauptfläche 31 angrenzen.

Das Substrat 30 besteht zum Beispiel aus monokristallinem Silizium. Die Gateelektroden 36 sind als implantierte Diffusionsgebiete im Substrat 30 realisiert (siehe Figur 6 und Figur 7) und durch pn-Übergänge gegen das Substrat 30 isoliert.

Das Gatedielektrikum 35 ist auf der Hauptfläche 31 angeordnet. Es überdeckt den gesamten Bereich für das Bauelement. Das Gatedielektrikum 35 umfaßt zum Beispiel $SiO_2$ und weist eine Dicke von zum Beispiel 10 nm auf.

An der Oberfläche des Gatedielektrikums 35 sind zwei Kontaktstrukturen 32 angeordnet. Die Kontaktstrukturen 32 bestehen zum Beispiel aus dotiertem Polysilizium oder einem Metall, vorzugsweise Aluminium oder Titan. Die Kontaktstrukturen 32 weisen eine Dicke von zum Beispiel 50 nm auf. Zwischen den Kontaktstrukturen 32 besteht ein Abstand von zum Beispiel 150 nm.

Die Gateelektroden 36 sind so im Substrat 30 angeordnet, daß sie zwischen den Kontaktstrukturen 32 liegen.

Die Schichtstruktur 33 ist an der Oberfläche des Gatedielektrikums 35 zwischen den Kontaktstrukturen 33 angeordnet. Die Schichtstruktur 33 wird aus den Einzelelementen 34 gebildet, die als einlagige Schicht zwischen den Kontaktstrukturen 32 angeordnet sind. Dabei berühren sich unmittelbar benachbarte Einzelelemente 34. Diejenigen Einzelelemente 34, die an einer einer der Kontaktstrukturen 32 benachbarten Kante der Schichtstruktur 33 angeordnet sind, berühren die Kontaktstruktur 32.

Die Einzelelemente 34 sind vorzugsweise Metallcluster mit 55 Goldatomen, die von einer isolierenden organischen Ligandenhülle umgeben sind. Die isolierenden Hüllen zwischen benachbarten Metallclustern bilden eine Coulomb-Barriere. Die Einzelelemente 34 weisen Abmessungen von etwa 2 nm auf. Alternativ können die Einzelelemente Metallcluster anderer Größe sein, die von einer isolierenden Hülle umgeben sind, oder Fullerene mit eingeschlossenem Metallkern oder aus porösem Halbleitermaterial bestehen.

Die Kontaktstrukturen 32 und die Schichtstruktur 33 sind durch das Gatedielektrikum 35 gegenüber dem Substrat 30 isoliert. Die Kontaktstruktur 32, die Schichtstruktur 33, das Gatedielektrikum 35 und die beiden Gateelektroden 36 bilden ein Bauelement, in dem durch Anlegen entsprechender Steuerspannungen an den Gateelektroden 36 Ladung getaktet von der einen Kontaktstruktur zur anderen verschoben werden kann. Es handelt sich um eine Elektronen-Pumpe nach einem ähnlichen Prinzip, wie es in C. Urbina et al, IEEE Trans. Magn. Bd. 27 (1991) S. 2578 ff. beschrieben ist.

**Patentansprüche**

1. Mikroelektronisches Bauelement,

   - bei dem ein Substrat (10) mit einer Hauptfläche (11) vorgesehen ist,

   - bei dem auf der Hauptfläche (11) des Substrats (10) eine Schichtstruktur (13) angeordnet ist, die in einer Lage nebeneinander angeordnete Einzelelemente (14) umfaßt,

   - bei dem auf der Hauptfläche (11) des Substrats (10) mindestens zwei Kontaktstrukturen (12) vorgesehen sind, die mit der Schichtstruktur (13) elektrisch verbunden sind.

   - bei dem die Einzelelemente (14) und die Kontaktstrukturen (12) gegenüber dem Substrat (10) elektrisch isoliert sind,

   - bei dem die Einzelelemente untereinander jeweils über quantenmechanische Tunnelkontakte elektrisch verbunden sind,

- bei dem der Durchmesser der Einzelelemente zwischen 1 und 10 nm liegt.

2. Bauelement nach Anspruch 1,

  - bei dem jedes Einzelelement (14) einen leitfähigen Kern und eine den leitfähigen Kern umgebende isolierende Hülle umfaßt,

  - bei dem der leitfähige Kern und die isolierende Hülle gemeinsam einen Durchmesser zwischen und 10 nm aufweisen,

  - bei dem benachbarte Einzelelemente (14) so angeordnet sind, daß sich ihre isolierenden Hüllen berühren.

3. Bauelement nach Anspruch 2,

  - bei dem jedes Einzelelement (14) ein Metallcluster mit organischen Liganden als isolierender Hülle oder ein Fulleren mit eingeschlossenem Metallkern umfaßt.

4. Bauelement nach Anspruch 1,

  bei dem die Einzelelemente (14) durch poröses Halbleitermaterial gebildet werden, das so stark ausgeätzt ist, daß keine durchgehende leitfähige Verbindung mehr besteht und bei dem die Einzelelemente (14) jeweils Abmessungen im Bereich zwischen 1 nm und 10 nm aufweisen.

5. Bauelement nach einem der Ansprüche 1 bis 4,

  bei dem die Kontaktstrukturen (12) an gegenüberliegenden Seiten der Schichtstruktur (13) angeordnet sind.

6. Bauelement nach Anspruch 5,

  bei dem die Schichtstruktur (13) parallel zum Abstand der Kontaktstrukturen (12) eine Ausdehnung zwischen 20 nm und 500 nm und senkrecht dazu eine Ausdehnung zwischen 20 nm und 10 μm aufweist.

7. Bauelement nach Anspruch 5 oder 6,

  - bei dem eine Oberfläche der Schichtstruktur (23, 33), die parallel zur Hauptfläche (21, 31) des Substrats (20, 30) ausgerichtet ist, mit einem Gatedielektrikum (25, 35) versehen ist,

  - bei dem auf der Oberfläche des Gatedielektrikums (25, 35) auf der von der Schichtstruktur (23, 33) abgewandten Seite mindestens eine Gateelektrode (26, 36) angeordnet ist.

8. Bauelement nach Anspruch 7,

  bei dem auf der Oberfläche des Gatedielektrikums (35) mindestens zwei Gateelektroden (36) angeordnet sind.

**Claims**

1. Microelectronic component,

  - in which a substrate (10) having a main face (11) is provided,

  - in which a layer structure (13), which comprises individual elements (14) arranged next to one another in a plane, is arranged on the main face (11) of the substrate (10),

  - in which at least two contact structures (12), which are electrically connected to the layer structure (13), are provided on the main face (11) of the substrate (10),

  - in which the individual elements (14) and the contact structures (12) are electrically insulated from the substrate (10),

  - in which the individual elements are respectively connected to one another electrically via quantum-mechanical tunnel contacts,

  - in which the diameter of the individual elements is between 1 and 10 nm.

2. Component according to Claim 1,

  - in which each individual element (14) comprises a conductive core and an insulating shell surrounding the conductive core,

  - in which the conductive core and the insulating shell together have a diameter of between 1 and 10 nm,

  - in which the neighbouring individual elements (14) are arranged in such a way that their insulating shells touch.

3. Component according to Claim 2,

  - in which each individual element (14) comprises a metal cluster with organic ligands as the insulating shell or a fullerene with an enclosed metal core.

4. Component according to Claim 1, in which the individual elements (14) are formed by porous semiconductor material which is etched to an extent such that there is no longer any continuous conductive connection, and in which the individual elements (14) have respective dimensions in the range between 1 nm and 10 nm.

**5.** Component according to one of Claims 1 to 4, in which the contact structures (12) are arranged on opposite sides of the layer structure (13).

**6.** Component according to Claim 5, in which the layer structure (13) has an extent of between 20 nm and 500 nm parallel to the spacing of the contact structures (12), and an extent of between 20 nm and 10 μm perpendicular thereto.

**7.** Component according to Claim 5 or 6,

- in which a surface of the layer structure (23, 33), which is aligned parallel with the main face (21, 31) of the substrate (20, 30), is provided with a gate dielectric (25, 35),
- in which at least one gate electrode (26, 36) is arranged on the surface of the gate dielectric (25, 35) on the other side from the layer structure (23, 33).

**8.** Component according to Claim 7, in which at least two gate electrodes (36) are arranged on the surface of the gate dielectric (35).

**Revendications**

**1.** Composant micro-électronique dans lequel

- il est prévu un substrat (10) ayant une surface principale (11),
- une structure en couche (13), qui comprend des éléments individuels (14) disposés les uns à côté des autres en une couche, est disposée sur la surface principale (11) du substrat (10),
- il est prévu sur la surface principale (11) du substrat (10) au moins deux structures de contact (12) qui sont reliées électriquement à la structure en couche (13),
- les éléments individuels (14) et les structures de contact (12) sont isolés électriquement du substrat (10),
- les éléments individuels sont reliés électriquement à chaque fois par l'intermédiaire de contacts tunnels en mécanique quantique,
- le diamètre des éléments individuels est compris entre 1 et 10 nm.

**2.** Composant selon la revendication 1, dans lequel

- chaque élément individuel (14) comprend un noyau conducteur et une enveloppe isolante entourant le noyau conducteur,
- le noyau conducteur et l'enveloppe isolante ont ensemble un diamètre compris entre 1 et 10 nm,
- des éléments individuels (14) voisins sont disposés de telle sorte que leurs enveloppes isolantes se touchent.

**3.** Composant selon la revendication 2, dans lequel chaque élément individuel (14) comprend un cluster métallique ayant des ligands organiques comme enveloppe isolante ou un fullerène avec noyau métallique inclus.

**4.** Composant selon la revendication 1, dans lequel les éléments individuels (14) sont formés par un matériau semi-conducteur poreux qui est si fortement attaqué chimiquement qu'il n'existe plus de liaison conductrice continue et dans lequel les éléments individuels (14) ont chacun des dimensions comprises entre 1 nm et 10 nm.

**5.** Composant selon l'une des revendications 1 à 4, dans lequel les structures de contact (12) sont disposées sur des côtés opposés de la structure en couche (13).

**6.** Composant selon la revendication 5, dans lequel la structure en couche (13) a parallèlement à la distance entre les structures de contact (12) une dimension comprise entre 20 nm et 500 nm et perpendiculairement à cette distance une dimension comprise entre 20 nm et 10 μm.

**7.** Composant selon la revendication 5 ou 6, dans lequel

- une surface de la structure en couche (23, 33) qui est dirigée parallèlement à la surface principale (21, 31) du substrat (20, 30) est munie d'un diélectrique de grille (25, 35),
- au moins une électrode de grille (26, 36) est disposée sur la surface du diélectrique de grille (25, 35) sur le côté opposé à la structure en couche (23, 33).

**8.** Composant selon la revendication 7, dans lequel au moins deux électrodes de grille (36) sont disposées sur la surface du diélectrique de grille (35).

FIG 1

FIG 2

FIG 3

**FIG 4**

**FIG 5**

FIG 6

FIG 7